(19) Europäisches Patentamt
European Patent Office
Office européen des brevets

(11) **EP 1 906 536 A2**

(12) **EUROPEAN PATENT APPLICATION**

(43) Date of publication:
**02.04.2008 Bulletin 2008/14**

(51) Int Cl.:
***H03M 13/29*** *(2006.01)*

(21) Application number: **07010406.2**

(22) Date of filing: **24.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **28.09.2006 US 847773 P**
 **25.10.2006 US 586101**

(71) Applicant: **Broadcom Corporation Irvine, CA 92617 (US)**

(72) Inventors:
• **Shen, Ba-Zhong**
 **Irvine, CA 92617 (US)**
• **Lee, Tak K.**
 **Irvine, CA 92617 (US)**

(74) Representative: **Jehle, Volker Armin Patentanwälte Bosch, Graf von Stosch, Jehle, Flüggenstrasse 13 80639 München (DE)**

(54) **Tail-biting turbo code for arbitrary number of information bits**

(57) Tail-biting turbo code for arbitrary number of information bits. A novel means is presented in which, for most cases, no extra symbols at all need to be padded to an input sequence to ensure that a turbo encoder operates according to tail-biting (i.e., where the beginning and ending state of the turbo encoder is the same). In a worst case scenario, only a single symbol (or a single bit) needs to be padded to the input sequence. Herein, all of the input bits of the input sequence are interleaved within the turbo encoding. In the instance where the at most one symbol (or at most one bit) needs to be padded to the input sequence, then that at most one symbol (or one bit) is also interleaved within the turbo encoding. Moreover, any size of an input sequence can be accommodated using the means herein to achieve tail-biting.

Fig. 1

**Description**

**CROSS REFERENCE TO RELATED PATENTS/PATENT APPLICATIONS**

**Provisional priority claims**

The present U.S. Utility Patent Application claims priority pursuant to 35 U.S.C. § 119(e) to the following U.S. Provisional Patent Application which is hereby incorporated herein by reference in its entirety and made part of the present U.S. Utility Patent Application for all purposes:

1. U.S. Provisional Application Serial No. 60/847,773, entitled "Tail-biting turbo code for arbitrary number of information bits," (Attorney Docket No. BP5739), filed 09/28/2006, pending.

**BACKGROUND OF THE INVENTION**

**TECHNICAL FIELD OF THE INVENTION**

The invention relates generally to communication systems; and, more particularly, it relates to tail-biting when encoding an input sequence within such communication systems employing turbo codes.

**DESCRIPTION OF RELATED ART**

Data communication systems have been under continual development for many years. One such type of communication system that has been of significant interest lately is a communication system that employs iterative error correction codes. One type of communication system that has received interest in recent years has been one which employs turbo codes (one type of iterative error correcting code). Communications systems with iterative codes are often able to achieve lower bit error rates (BER) than alternative codes for a given signal to noise ratio (SNR).

A continual and primary directive in this area of development has been to try continually to lower the SNR required to achieve a given BER within a communication system. The ideal goal has been to try to reach Shannon's limit in a communication channel. Shannon's limit may be viewed as being the data rate to be used in a communication channel, having a particular SNR, that achieves error free transmission through the communication channel. In other words, the Shannon limit is the theoretical bound for channel capacity for a given modulation and code rate.

The use of turbo codes providing such relatively lower error rates, while operating at relatively low data throughput rates, has largely been in the context of communication systems having a large degree of noise within the communication channel and where substantially error free communication is held at the highest premium. Some of the earliest application arenas for turbo coding were space related where accurate (i.e., ideally error free) communication is often deemed an essential design criterion. The direction of development then moved towards developing terrestrial-applicable and consumer-related applications. Still, based on the heritage of space related application, the focus of effort in the turbo coding environment then continued to be achieving relatively lower error floors, and not specifically towards reaching higher throughput.

More recently, focus in the art has been towards developing turbo coding, and variants thereof, that are operable to support higher amounts of throughput while still preserving the relatively low error floors offered within the turbo code context.

Generally speaking, within the context of communication systems that employ turbo codes, there is a first communication device at one end of a communication channel with encoder capability and second communication device at the other end of the communication channel with decoder capability. In many instances, one or both of these two communication devices includes encoder and decoder capability (e.g., within a bi-directional communication system).

**BRIEF SUMMARY OF THE INVENTION**

The present invention is directed to apparatus and methods of operation that are further described in the following Brief Description of the Several Views of the Drawings, the Detailed Description of the Invention, and the claims.

According to an aspect of the invention, an encoder that is operable to perform tail-biting when encoding an input sequence is provided, the encoder comprising:

a buffer that is operable to receive the input sequence;
a turbo encoder that is operable to receive the input sequence from the buffer and to encode the input sequence; and
a processing module that, based on the input sequence, is operable to determine a state of the turbo encoder and at most one symbol to be padded to the input sequence such that the state of the turbo encoder before encoding a first symbol of the input sequence is same as the state of the turbo encoder upon encoding a final symbol of the input sequence or the at most one symbol that has been padded to the input sequence; and wherein:
the buffer is operable to provide the input sequence to the turbo encoder when the processing module determines the state; and
the turbo encoder is in the state that is determined by the processing module before encoding the first symbol of the input sequence and after encoding the final symbol of the input sequence or the at most one symbol that has been padded to the input sequence.

Advantageously:

at least one of the first symbol and the second symbol includes only one bit.

Advantageously:

the processing module is operable to provide the at most one symbol to be padded to the input sequence to the turbo encoder after the buffer provides the input sequence to the turbo encoder.

Advantageously, the encoder further comprises:

a puncturing module that is operable to puncture at least one bit within an encoded sequence output from the turbo encoder.

Advantageously:

based on the input sequence, the processing module is operable to determine that no symbol needs to be padded to the input sequence to ensure that the state of the turbo before encoding a first symbol of the input sequence is same as the state of the turbo encoder upon encoding a final symbol of the input sequence.

Advantageously, the encoder further comprises:

a memory, coupled to the processing module, that is operable to store operational instructions that enable the processing module to, based on the input sequence, determine the state of the turbo encoder such that the turbo encoder is in the state when encoding the first symbol of the input sequence and in the state when encoding the final symbol of the input sequence.

Advantageously:

the state is a first state;
the input sequence is a first input sequence;
the at most one symbol is a first at most one symbol;
the turbo encoder is in the first state before encoding the first symbol of the first input sequence and after encoding the final symbol of the first input sequence or the first at most one symbol that has been padded to the first input sequence; and
the turbo encoder is in the second state before encoding a first symbol of a second input sequence and after encoding a final symbol of a second input sequence or a second at most one symbol that has been padded to the second input sequence.

Advantageously:

the turbo encoder is an m state encoder, where m is an integer; and
at most one symbol is padded to the input sequence to assist the turbo encoder to perform tail-biting.

Advantageously:

the turbo encoder includes an interleaver; and
all symbols of the input sequence, as well as the at most one symbol that is padded to the input sequence if determined necessary by the processing module, undergo interleaving within the interleaver of the turbo encoder.

Advantageously:

the encoder is implemented within a communication device; and
the communication device is implemented within at least one of a satellite communication system, a wireless communication system, a wired communication system, and a fiber-optic communication system.

According to an aspect of the invention, an encoder is provided that is operable to perform tail-biting when encoding an input sequence, the encoder comprising:

a turbo encoder that is operable to receive an input sequence and to encode either:

the input sequence; or
the input sequence and at most one zero valued symbol that is padded to the input sequence; and

a processing module that, based on the input sequence, is operable to determine a starting state of the turbo encoder, and to provide the starting state to the turbo encoder, so that the starting state of the turbo encoder before encoding a first symbol of the input sequence is same as an ending state of the turbo encoder upon encoding either a final symbol of the input sequence or the at most one zero valued symbol when padded to the input sequence.

Advantageously:

at least one of the first symbol and the second symbol includes only one bit.

Advantageously, the encoder further comprises:

a buffer that is operable to receive the input sequence; and wherein:

the buffer provides the input sequence to the turbo decoder after the processing module determines the starting state of the encoder; and
the processing module provides the at most one zero valued symbol, when determined necessary by the processing module, to the turbo encoder after the buffer provides the input sequence to the turbo decoder.

Advantageously:

the turbo encoder is an m state encoder, where m is an integer; and
at most one symbol is padded to the input sequence to assist the turbo encoder to perform tail-biting.

Advantageously:

the encoder is implemented within a communication device; and
the communication device is implemented within at least one of a satellite communication system, a wireless communication system, a wired communication system, and a fiber-optic communication system.

According to an aspect of the invention, a method is provided for performing tail-biting within a turbo encoder that encodes an input sequence, the method comprising:

determining a state of the turbo encoder and at most one symbol to be padded to the input sequence such that the state of the turbo encoder before encoding a first symbol of the input sequence is same as the state of the turbo encoder upon encoding either a final symbol of the input sequence or the at most one symbol, if necessary, that has been padded to the input sequence; and
turbo encoding either the input sequence or the input sequence and the at most one symbol, if necessary, so that the turbo encoder is in the state before encoding the first symbol of the input sequence and is in the state after encoding either the final symbol of the input sequence or the at most one symbol, if necessary, that has been padded to the input sequence.

Advantageously, the method further comprises:

at least one of the first symbol and the second symbol includes only one bit.

Advantageously:

the at most one symbol is a zero valued symbol that includes only one bit.

Advantageously, the method further comprises:

interleaving all symbols of the input sequence, including the at most one symbol, if necessary, that has been padded to the input sequence, when performing turbo encoding thereon.

Advantageously:

the method is performed within a communication device; and
the communication device is implemented within at least one of a satellite communication system, a wireless communication system, a wired communication system, and a fiber-optic communication system.

Other features and advantages of the present invention will become apparent from the following detailed description of the invention made with reference to the accompanying drawings.

**BRIEF DESCRIPTION OF THE SEVERAL VIEWS OF THE DRAWINGS**

FIG. 1 illustrates an embodiment of a communication system.
FIG. 2 illustrates another embodiment of a communication system.
FIG. 3 and FIG. 4 illustrate embodiment of communication devices that perform turbo encoding.
FIG. 5 illustrates an embodiment of a performance comparison between various types of turbo coding.
FIG. 6 illustrates an embodiment of a first constituent encoder of Rel.6 as can be implemented within a turbo encoder.
FIG. 7 illustrates an embodiment of a duo-binary turbo encoder.
FIG. 8 illustrates an embodiment of a method for performing tail-biting within a turbo encoder that encodes an input sequence.

**DETAILED DESCRIPTION OF THE INVENTION**

Many communication systems incorporate the use of a turbo code. When performing encoding of an input sequence within such turbo encoders, it is oftentimes desirable to ensure that the beginning and/or at least the ending state of the encoder is at a known state.

Some means by which an encoder can be returned to a known state at the end of encoding an input sequence include: (1) adding 2m bits outside of the interleaver of the turbo encoder for a constituent convolutional encoder having $2^m$ states (where m is an integer), and (2) the means as provided in commonly assigned U.S. patent no. 7,085,985, entitled "Close two constituent trellis of a turbo encoder within the interleave block".

For a given input sequence, when both the first and last state of the encoder is the same, this can referred to as tail-biting. Also, with respect to decoding of turbo coded signals, forward and backward turbo decoding approaches rely on the known initial and final states of the encoder when encoding the input sequence that generates the turbo coded signal.

Tail-biting termination, which gives equal states at the beginning and the end of encoding of an input sequence, serves this purpose. A means is presented herein to perform tail-biting termination of an encoder without adding any extra terminating symbols (or bits).

While some approaches can provide for tail-biting for one particular type of turbo code having a particular input sequence block size, these approaches do provide for any means by which various block sizes can be accommodated without a nearly complete re-hauling and design to enable tail-biting. In other words, these approaches simply cannot accommodate an arbitrary number of information bits within the input sequence.

In certain applications, such as the LTE encoder, it would desirable to support arbitrary number of information bits from a consecutive range of integers (e.g. Rel.6 supports the size from 40 to 5114). As pointed out in R1-062157 [1], Rel.6 turbo encoder [2] can not provide tail-biting state for 1/7 of all of the possible information sequences.

Herein, it is first shown that all turbo codes have a similar problem. A detailed analysis is provided herein for selecting a tail-biting encoder from among all possible 8 states turbo codes. Then, a novel approach is presented which can accommodate all possible information sequences and provide for tail-biting termination with at most one extra symbol (or bit) that is passed through the interleaved block of the turbo encoder.

While there are many potential applications that can employ turbo codes, means are presented herein that can be applied to the 3GPP channel code to support an arbitrary number of information bits. Some examples of the number of bits that can be supported using the various aspects of the invention presented herein are 40 to 5114 for WCDMA and HSDPA and more for LTE.

Additional information regarding the UTRA-UTRAN Long Term Evolution (LTE) and 3GPP System Architecture Evolution (SAE) can be found at the following Internet web site:

www.3gpp.org

In one proposed implementation therein, the current channel coding uses an 8 state turbo code with 6 termination bits added, and these 6 termination bits are not passed through the interleave of the turbo encoder. To save the rate loss and to improve the performance, a tail-biting recursive convolutional encoder would be better to be used as the constituent encoders of the turbo encoder.

However, many in the art operate on the supposition that it is not possible for a recursive convolutional encoder to have tail-biting state for an arbitrary number of information bits.

Herein, a novel means is presented by which tail-biting can be performed for a recursive convolutional encoder to support any number of information bits. The overhead of this novel means is either no additional symbols (or bits) to be padded to the input sequence, or at most only one dummy symbol (or bit) to be padded to the input sequence. Moreover, the added one bit is also interleaved. Using this means, there is no performance loss when compared to other approaches.

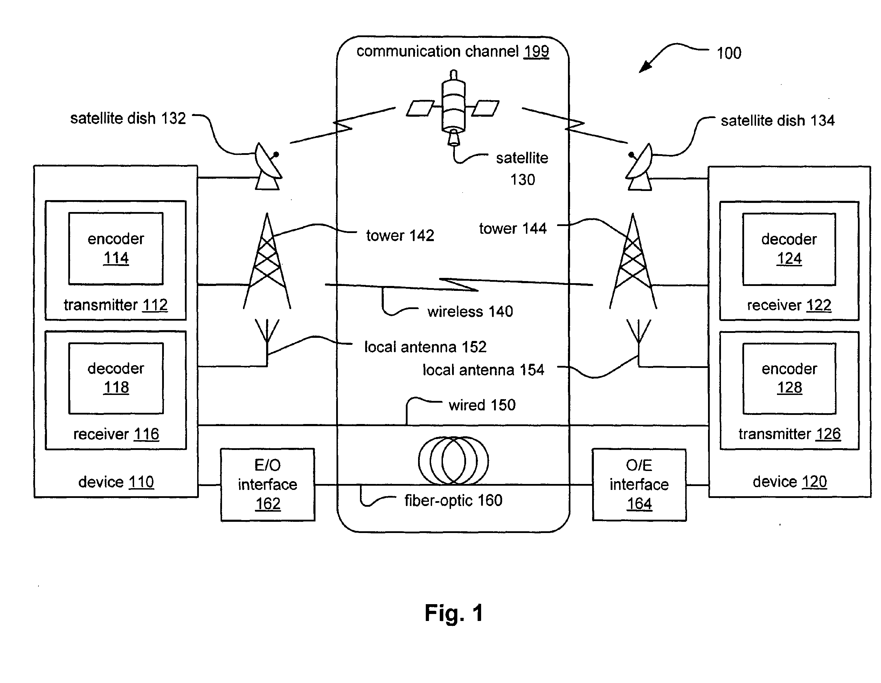

The goal of digital communications systems is to transmit digital data from one location, or subsystem, to another either error free or with an acceptably low error rate. As shown in FIG. 1, data may be transmitted over a variety of communications channels in a wide variety of communication systems: magnetic media, wired, wireless, fiber, copper, and other types of media as well.

FIG. 1 is a diagram illustrating an embodiment of a communication system 100.

Referring to FIG. 1, this embodiment of a communication system 100 is a communication channel 199 that communicatively couples a communication device 110 (including a transmitter 112 having an encoder 114 and including a receiver 116 having a decoder 118) situated at one end of the communication channel 199 to another communication device 120 (including a transmitter 126 having an encoder 128 and including a receiver 122 having a decoder 124) at the other end of the communication channel 199. In some embodiments, either of the communication devices 110 and 120 may only include a transmitter or a receiver. There are several different types of media by which the communication channel 199 may be implemented (e.g., a satellite communication channel 130 using satellite dishes 132 and 134, a wireless communication channel 140 using towers 142 and 144 and/or local antennae 152 and 154, a wired communication channel 150, and/or a fiber-optic communication channel 160 using electrical to optical (E/O) interface 162 and optical to electrical (O/E) interface 164)). In addition, more than one type of media may be implemented and interfaced together thereby forming the communication channel 199.

To reduce transmission errors that may undesirably be incurred within a communication system, error correction and channel coding schemes are often employed. Generally, these error correction and channel coding schemes involve the use of an encoder at the transmitter and a decoder at the receiver.

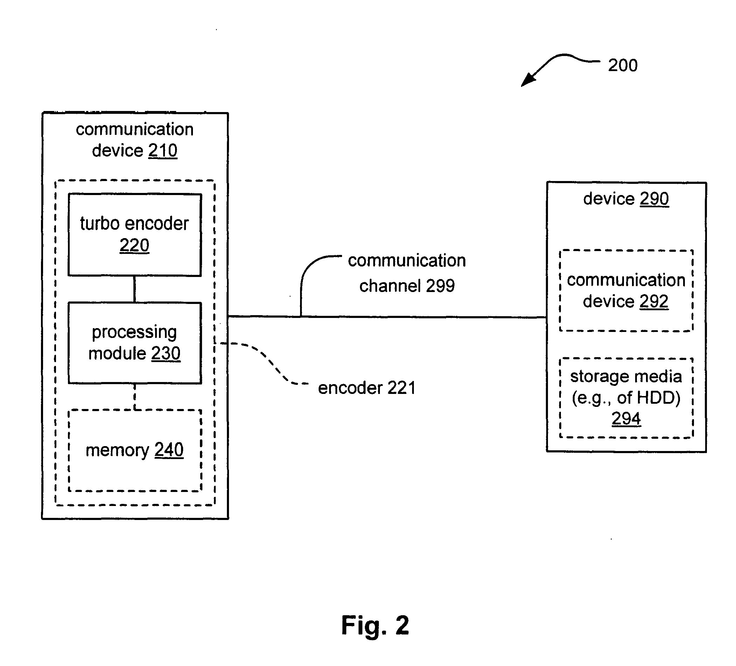

FIG. 2 illustrates another embodiment of a communication system 200. Referring to FIG. 2, a communication system 200 includes a communication device 210 that is coupled to another device 290 via a communication channel 299. The communication device 210 includes an encoder 221 and could also include a decoder.

The other device 290 to which the communication device 210 is coupled via the communication channel 299 can be another communication device 292, a storage media 294 (e.g., such as within the context of a hard disk drive (HDD)), or any other type of device that is capable to receive and/or transmit signals. In some embodiments, the communication channel 299 is a bi-directional communication channel that is operable to perform transmission of a first signal during a first time and receiving of a second signal during a second time. If desired, full duplex communication may also be employed, in which each of the communication device 210 and the device 290 can be transmitted and/or receiving from one another simultaneously.

The encoder 221 of the communication device 210 includes a turbo encoder and a processing module 230. The processing module 230 may also be coupled to a memory 240 to store operational instructions that enable to the processing module 230 to perform certain functions. Generally speaking, based on a particular input sequence, the processing module 230 is operable to perform the determination of which state the turbo encoder should begin in to support tail-biting when encoding that input sequence.

It is also noted that the processing module 230 can be implemented strictly as circuitry. Alternatively, the processing module 230 can be implemented strictly in software such as can be employed within a digital signal processor (DSP) or similar type device. In even another embodiment, the processing module 230 can be implemented as a combination of hardware and software as well without departing from the scope and spirit of the invention.

In even other embodiments, the processing module 230 can be implemented using a shared processing device, individual processing devices, or a plurality of processing devices. Such a processing device may be a microprocessor, microcontroller, digital signal processor, microcomputer, central processing unit, field programmable gate array, programmable logic device, state machine, logic circuitry, analog circuitry, digital circuitry, and/or any device that manipulates signals (analog and/or digital) based on operational instructions. The processing module 230 can be coupled to the memory 240 that is operable to store operational instructions that enable to processing module 230 to perform the determination of the appropriate state to be employed when beginning fo encode an input sequence to ensure tail-biting operation b the turbo encoder 220.

Such a memory 240 may be a single memory device or a plurality of memory devices. Such a memory 240 may be a read-only memory, random access memory, volatile memory, non-volatile memory, static memory, dynamic memory, flash memory, and/or any device that stores digital information. Note that when the processing module 230 implements one or more of its functions via a state machine, analog circuitry, digital circuitry, and/or logic circuitry, the memory storing the corresponding operational instructions is embedded with the circuitry comprising the state machine, analog circuitry, digital circuitry, and/or logic circuitry.

Within the encoder 221, the turbo encoder 220 is operable to receive an input sequence and to encode either (1) the input sequence, or the input sequence and at most one zero valued symbol (or bit) that is padded to the input sequence.

Based on the input sequence, the processing module 230 is operable to determine a starting state of the turbo encoder 220, and to provide the starting state to the turbo encoder 220, so that the starting state of the turbo encoder 220 before encoding a first symbol of the input sequence is same as an ending state of the turbo encoder upon encoding either a final symbol of the input sequence or the at most one zero valued symbol when padded to the input sequence.

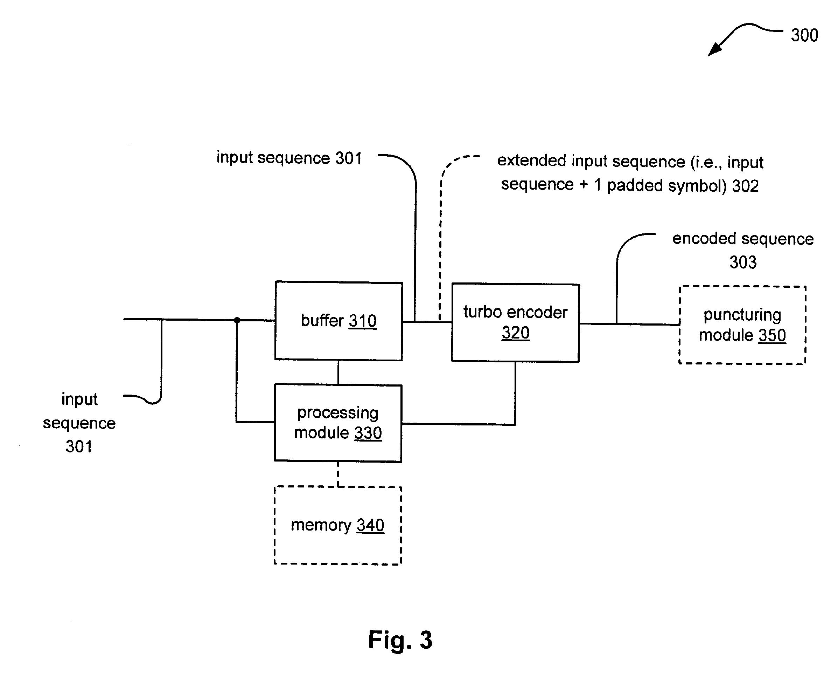

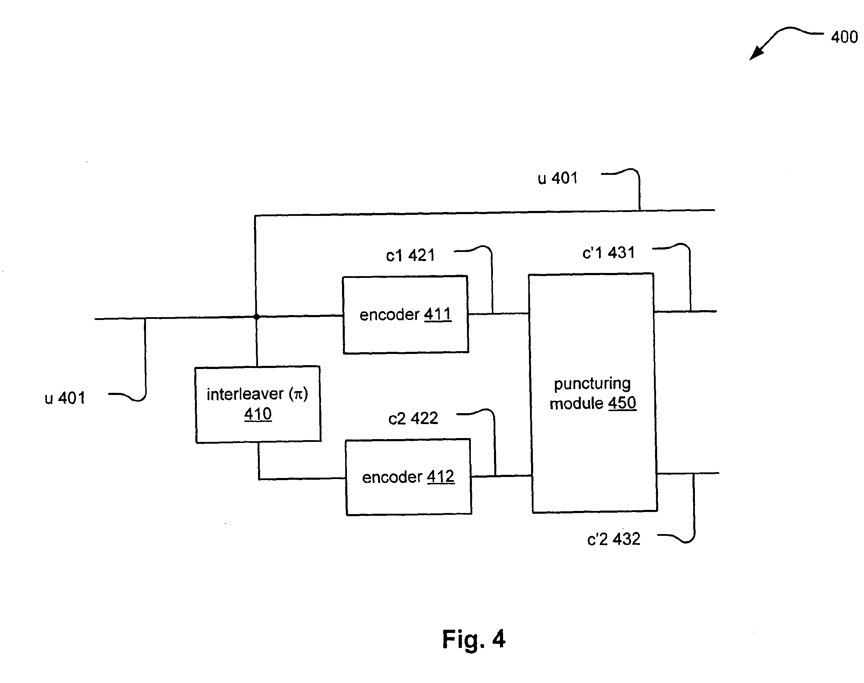

FIG. 3 and FIG. 4 illustrate embodiment of communication devices 300 and 400 that perform turbo encoding.

Referring to FIG. 3, the communication device 300 includes an encoder that is operable to perform tail-biting when encoding an input sequence using a turbo code. The communication device 300 includes a buffer 310, a processing module 330, a turbo encoder 320, and can also include a memory 340 and a puncturing module 350.

The buffer 310 is operable to receive the input sequence that is to be encoded. The turbo encoder 320 is operable to receive the input sequence from the buffer 310 and to encode the input sequence. Based on the input sequence, the processing module 330 is operable to determine a state of the turbo encoder 320 and at most one symbol to be padded to the input sequence such that the state of the turbo encoder 320 before encoding a first symbol of the input sequence is same as the state of the turbo encoder upon encoding a final symbol of the input sequence or the at most one symbol that has been padded to the input sequence. In other words, the turbo encoder 320 is operable to receive the input sequence from the buffer 310 and to encode either (1) the input sequence as indicated by reference numeral 301, or the input sequence and at most one zero valued symbol (or bit) that is padded to the input sequence as indicated by the reference numeral 302. When at most one zero valued symbol (or bit) is padded to the input sequence, the "modified" input sequence can be referred to as an extended input sequence 302.

The buffer 310 is operable to provide the input sequence to the turbo encoder 320 when the processing module determines the state, and the turbo encoder 320 is in the state that is determined by the processing module before encoding the first symbol of the input sequence and after encoding the final symbol of the input sequence or the at most one symbol that has been padded to the input sequence. If desired, the puncturing module 350 is operable to puncture one or more bits of an encoded sequence that is output from the turbo encoder 303.

Referring to FIG. 4, the communication device 400 employs a turbo encoding arrangement that includes a first constituent encoder 411 and a second constituent encoder 412, an interleaver ($\pi$) 410, and a puncturing module 450. Let $u_0, u_1, ..., u_{k-1}$ be input sequence (referred to as u 401) to one of the encoders (e.g., first constituent encoder 411) of a turbo code such that $S_0, S_1, ..., S_k$ be the corresponded states sequence. The encoding is tail-biting (or circular) for this given information sequence if and only is $S_0 = S_k$.

The input sequence 401 is provided to the first constituent encoder 411 and to the interleaver ($\pi$) 410. The output of the first constituent encoder 411 is shown as c1 421. The output of the interleaver ($\pi$) 410 is then provided to the second constituent encoder 412, whose output is shown as c2 422. Each of c1 421 and c2 422 is provided to the puncturing module 431 where none, one or more bits of c 1 421 and/or c2 422 is punctured thereby generating the outputs c'1 431 and c'2 432. Information bits, shown as u 401 at the top of the diagram, can also be employed as output from the communication device 400.

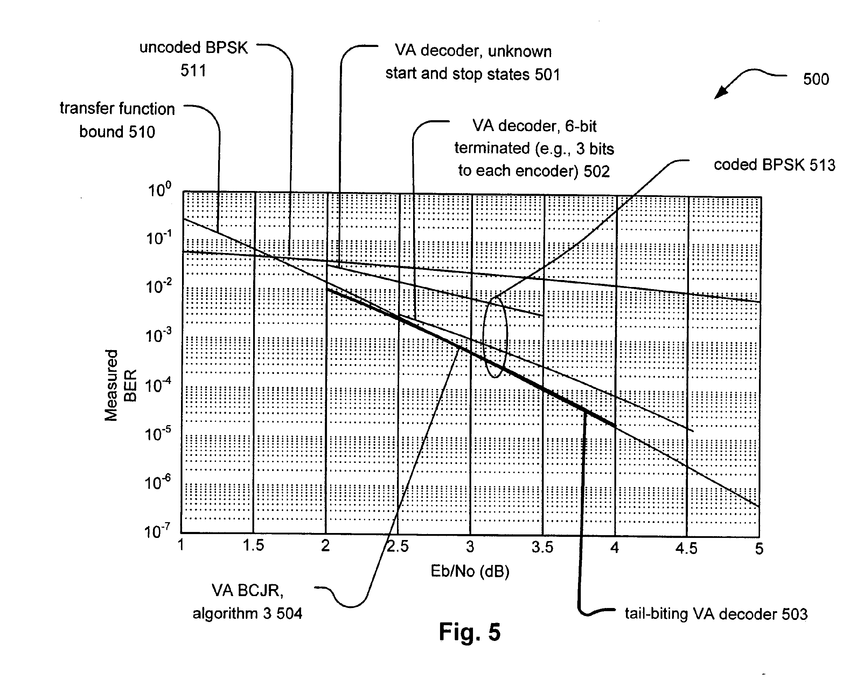

FIG. 5 illustrates an embodiment of a performance comparison 500 between various types of turbo coding. In this disclosure, this performance diagram is described in the context of measured BER (Bit Error Rate) versus $E_b/N_o$ (ratio of energy per bit $E_b$ to the Spectral Noise Density $N_o$). . In some other communication system application, performance may be viewed in terms of BER (Bit Error Rate) vs. $E_b/N_o$. This term $E_b/N_o$ is the measure of SNR (Signal to Noise Ratio) for a digital communication system. When looking at these performance curves, the BER may be determined for any given $E_b/N_o$ (or SNR) thereby providing a relatively concise representation of the performance of the decoding approach.

The performance curve in FIG. 5 cited from [3] shows the benefit of using tail-biting encoding. Several different types of coding are depicted in this diagram, including the performance curves of the transfer function bound (as shown by reference numeral 510), uncoded BPSK (Binary Phase Shift Keying) (as shown by reference numeral 511), coded BPSK (as shown by reference numeral 513 circling the 3 coded BPSK performance curves), a VA (Viterbi Algorithm) decoder having unknown start and stop states (as shown by reference numeral 501), a VA decoder having employing 6-bits to terminate the encoders (e.g., 3 bits to each of the 2 constituent encoders) (as shown by reference numeral 502), VA BCJR (Bahl-Cocke-Jelinek-Raviv) algorithm 3 (shown by reference numeral 504), and a tail-biting VA decoder 503.

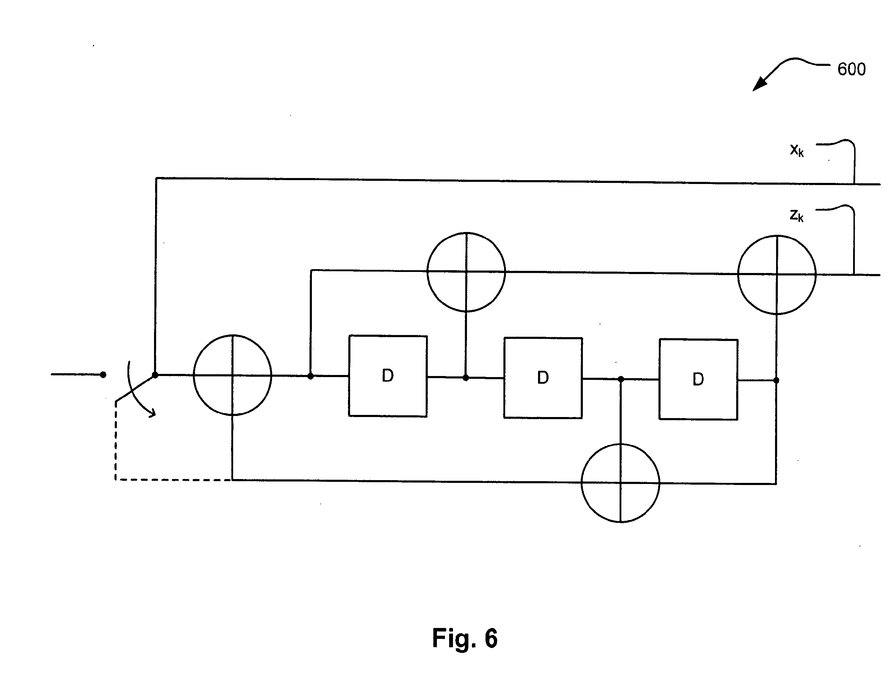

FIG. 6 illustrates an embodiment of a first constituent encoder 600 of Rel.6 as can be implemented within a turbo encoder.

The definition of state-space realization of convolutional encoder is employed herein as described in [4-6]. With this realization a necessary and sufficient condition of a tail-biting minimal encoder, a novel means is presented herein to accommodate an information sequence of any arbitrary size.

Consider a rate $k_0/n_0$ convolutional encoder of degree $m$, let the input sequence be as follows:

$\mathbf{u} = (u_0,...,u_{N-1})$ where $u_i = (u_{i,k_0-1},...,u_{i,0})$ and the output sequence $\mathbf{x}=(x_0,...,x_{N-1})$ where $x_i =(x_{i,n_0-1},..., x_{i,0})$ $x_i =(x_{i,n_0-1}\cdots, x_{i,0})$.

Moreover, let $\mathbf{S}_t = \left(S_{m-1}^{(t)},...,S_0^{(t)}\right)$ be the encoding state at time $t$. Then there exits $m \times m$ matrix $A$, $m \times k_0$ matrix $B$, $k_0 \times m$ matrix $C$, and $k_0 \times n_0$ matrix $D$, which is called state-space realization of the encoder, such that

$$\mathbf{S}_t^T = \left(S_{m-1}^{(t)},...,S_0^{(t)}\right)^T = A\left(S_{m-1}^{(t-1)},...,S_0^{(t-1)}\right)^T + Bu_t^T = A\mathbf{S}_{t-1}^T + Bu \qquad \text{(EQ-1)}$$

and $x_t^T = C\mathbf{S}_{t-1}^T + Du_t^T$. The generate matrix of this convolutional encoder is

$$C(A,B,C,D) = G(x) = D + C(x^{-1}I_m - A)^{-1}B \qquad \text{(EQ-2)}$$

**Example 1** Consider convolutional encoder in Rel.6 turbo code depicted in FIG. 6. The encoder has degree 3 and

$$s_0^t = s_2^{t-1} + s_1^{t-1} + u_t, s_1^t = s_0^{t-1}, s_2^t = s_1^{t-1}.$$

Thus,

$$A = \begin{bmatrix} 0 & 1 & 0 \\ 0 & 0 & 1 \\ 1 & 1 & 0 \end{bmatrix}, B = \begin{bmatrix} 0 \\ 0 \\ 1 \end{bmatrix}, C = \begin{bmatrix} 1 & 0 & 1 \\ 0 & 0 & 0 \end{bmatrix}, D = \begin{bmatrix} 1 \\ 1 \end{bmatrix}$$

In [7], a sufficient condition is given for an encoder being tail-biting for any information sequence with a given block size. In the following, we prove this condition is necessary for an encoder with minimal degree (i.e. the number of states cannot be reduced).

**Theorem 1** Let the matrices $(A, B, C, D)$ be the state-space realization of a convolutional encoder with minimal degree $m$. This encoder is tail-biting for any information sequence of block size $N \geq m$ if and only if $A^N + I_m$ is invertible.

*Proof* Let $\mathbf{u} = (u_0,...,u_{N-1})$ be any information sequence of size $N$. Let $\left(S_{m-1}^{(N)}, \cdots, S_0^{(N)}\right)^T$ be the final state of the encoding with the given information sequence, than by (EQ-1) we have

$$\left(s_{m-1}^{(N)},\cdots,s_{0}^{(N)}\right)^{T} = A^{N}\left(s_{m-1}^{(0)},\cdots,s_{0}^{(0)}\right)^{T} + \sum_{r=0}^{N-1} A^{N-1-r} B u_{r}^{T}$$

Thus, the encoding is tail-biting for the given sequence if and only if $\left(s_{0}^{(N)},\cdots,s_{m-1}^{(N)}\right) = \left(s_{0}^{(0)},\cdots,s_{m-1}^{(0)}\right).$

This implies that the encoding is tail-biting for a given sequence if and only if there is a solution to the system of linear equations

$$(A^{N} + I_{m})(s_{0}^{(0)},\cdots,s_{m-1}^{(0)})^{T} = \sum_{r=0}^{N-1} A^{N-1-r} B u_{r}^{T} \qquad \text{(EQ-3)}$$

where $I_m$ is $m \times m$ binary identity matrix. On the other hand, by [6], degree $m$ is minimal if and only if the $m$ matrices $B$,

$AB,...,A^{m-1}B$ are linear independent. This implies that $\sum_{r=0}^{N-1} A^{N-1-r} B u_{r}^{T}$ can run over entire space $\{0,1\}^m$ when $N \geq m$

with all possible input sequences of size N. This implies (EQ-3) has a solution for all possible information sequences if and only if $A^N + I_m$ is invertible.

Nonexistence of tail-biting states for any turbo code

**Theorem 2** Given any turbo encoder $E$ with minimal degree of constituent encoders, there exists a positive integer $P$ such that, $E$ gives no tail-biting termination for some information sequences of size $tP$ $(t > 0)$.

*Proof.* Let $(A, B, C, D)$ be the state-space realization of one of the convolutional encoders of the given turbo code with $2^m$ states . Since there are finite number of $m \times m$ binary matrices there exist two positive integers, $u$ and $v$, such that

$A^u = A^v$. Suppose $u < v$. then we have $A^u (A^{(v-u)} + I_m)= 0$. Let $P=v-u$, we have

    a) Both $A^u$ and $A^p + I_m$ is non-invertible
    b) $A^u$ invertible but $A^P + I_m = 0$ (i.e., non-invertible)
    c) $A^P + I_m$ invertible but $A^u = 0$. This implies $G(x)=D+B(x^{-1}I_m-A)^{-1}C$ is a polynomial matrix [8]. Thus the encoder is non-recursive. This contradicts to the very definition of a turbo code [9].

Therefore, $A^P + I_m$ must be non-invertible. Moreover, for any integer $t > 0$ , suppose

$$A^{tP} + I_{m} = (A^{P} + I_{m})(A^{(t-1)P} + A^{(t-2)P} + \cdots + I_{m}) \cdot$$

is invertible. Then there exists and $m$ x $m$ matrix V such that

$$\left(A^{P} + I\right)\left(A^{(t-1)P} + A^{(t-2)P} + \cdots + I_{m}\right)V = I_{m}$$

That is to say $A^p + I_m$ is invertible, which contradicts the previous conclusion. Therefore, $A^{tP} + I_m$ is also non-invertible. Thus by Theorem 1, the turbo encoder does not give tail-biting termination for some information sequence of size $tP$.

Based on Theorem 2 there is no need to choose other turbo code for tail-biting purpose.

8 states (m=3) turbo codes

In this section we investigate all possible degree 3 convolutional encoders for turbo code and try to find which one is best for tail-biting. Let us recall the definition of similarity of two $m \times m$ matrices. Two $m \times m$ matrices $A_1$ and $A_2$ are said similar if there exists a invertible matrix $S$ such that $A_1 = SA_2S^{-1}$. It is easy to prove that code with state-space realization $(A,B,C,D)$ and $(SAS^{-1}, SB, CS^{-1}, D)$ have the same encoder matrix $G(x)$ (also see [10]). The set of all 3 x 3 binary matrices can be partitioned into several classes such that every class contains all similar matrices. Those classes also can be divided to 3 big categories, namely: (1) classes with nilpotent matrix, (2) classes with non-invertible and non-nilpotent, and (3) classes with invertible matrices. In fact, there are 14 classes. Therefore, we only need to consider 14 matrices that are representative of each class.

(1) Nilpotent (3 representatives)

$$A_1 = \begin{bmatrix} 0 & 0 & 0 \\ 0 & 0 & 0 \\ 0 & 0 & 0 \end{bmatrix}, \quad A_2 = \begin{bmatrix} 0 & 1 & 0 \\ 0 & 0 & 0 \\ 0 & 0 & 0 \end{bmatrix}, \quad A_3 = \begin{bmatrix} 0 & 1 & 0 \\ 0 & 0 & 1 \\ 0 & 0 & 0 \end{bmatrix}$$

Obviously, these matrices are none recursive and will not be considered as a constituent encoder of turbo code

(2) Non-invertible and non-nilpotent (5 representatives)

$$A_4 = \begin{bmatrix} 1 & 0 & 0 \\ 0 & 0 & 0 \\ 0 & 0 & 0 \end{bmatrix}, \quad A_5 = \begin{bmatrix} 0 & 1 & 0 \\ 1 & 0 & 0 \\ 0 & 0 & 0 \end{bmatrix}, \quad A_6 = \begin{bmatrix} 1 & 1 & 0 \\ 1 & 0 & 0 \\ 0 & 0 & 0 \end{bmatrix}, \quad A_7 = \begin{bmatrix} 1 & 0 & 0 \\ 0 & 1 & 0 \\ 0 & 0 & 0 \end{bmatrix}$$

Encoder with these 4 state matrices will give a disconnected memory. The encoder with disconnected memory will not give the best $d_2$ needed by turbo codes [10].

$$A_8 = \begin{bmatrix} 1 & 1 & 0 \\ 0 & 0 & 1 \\ 0 & 0 & 0 \end{bmatrix} \rightarrow A_8^t = \begin{bmatrix} 1 & 1 & 1 \\ 0 & 0 & 0 \\ 0 & 0 & 0 \end{bmatrix}, \quad t > 1 \rightarrow A_8^t + I_3 = \begin{bmatrix} 0 & 1 & 0 \\ 0 & 1 & 1 \\ 0 & 0 & 1 \end{bmatrix}$$

Since $A_8^3 + I_3$ is non-invertible, according to Theorem 1 the encoder (A,B,C,D) either is not minimal degree or it is not tail-biting for some information sequences. For examples, a) take B=[1 1 1]$^T$, we have BA=[0 1 0]$^T$ and BA$^2$= [1 0 1]$^T$. Then (EQ-3) has no solution for many information sequences of size >2; b) take B=[1 1 0]$^T$, then the encoder can be reduced to a degree 2 encoder *(A ',B',C',D)* with

$$A' = \begin{bmatrix} 1 & 1 \\ 0 & 1 \end{bmatrix} \quad \text{and} \quad B' = \begin{bmatrix} 1 \\ 1 \end{bmatrix}.$$

(3) Invertible (6 representatives)
$A_9 = I_3$ which gives a disconnected memory encoder.

$$A_{10} = \begin{bmatrix} 0 & 0 & 1 \\ 0 & 1 & 0 \\ 1 & 0 & 0 \end{bmatrix} \rightarrow A_{10}^2 = I_3, \quad A_{11} = \begin{bmatrix} 1 & 0 & 1 \\ 0 & 1 & 0 \\ 1 & 0 & 0 \end{bmatrix} \rightarrow A_{11}^3 = I_3$$

The encoders with these matrices have disconnected memory.

$$A_{12} = \begin{bmatrix} 0 & 1 & 0 \\ 1 & 0 & 1 \\ 1 & 0 & 0 \end{bmatrix} \rightarrow A_{12}^4 = I,, A_{12}^2 + I = \begin{bmatrix} 0 & 0 & 1 \\ 0 & 0 & 1 \\ 0 & 0 & 0 \end{bmatrix}, A_{12}^3 + I = \begin{bmatrix} 1 & 1 & 1 \\ 1 & 1 & 0 \\ 0 & 0 & 0 \end{bmatrix}$$

$$A_{13} = \begin{bmatrix} 0 & 1 & 0 \\ 0 & 0 & 1 \\ 1 & 1 & 0 \end{bmatrix} \rightarrow A_{13}^7 = I, A_{13}^1 + I_3 = \begin{bmatrix} 1 & 1 & 0 \\ 0 & 1 & 1 \\ 1 & 1 & 1 \end{bmatrix}$$

The turbo code of Rel.6 uses convolutional encoder with $A_{13}$ as a state matrix. Further more we have

$$A_{13}^2 = \begin{bmatrix} 0 & 0 & 1 \\ 1 & 1 & 0 \\ 0 & 1 & 1 \end{bmatrix}, A_{13}^2 + I_3 = \begin{bmatrix} 1 & 0 & 1 \\ 1 & 0 & 0 \\ 0 & 1 & 0 \end{bmatrix}, A_{13}^3 = \begin{bmatrix} 1 & 1 & 0 \\ 0 & 1 & 1 \\ 1 & 1 & 1 \end{bmatrix}, A_{13}^3 + I_3 = \begin{bmatrix} 0 & 1 & 0 \\ 0 & 0 & 1 \\ 1 & 1 & 0 \end{bmatrix},$$

$$A_{13}^4 = \begin{bmatrix} 0 & 1 & 1 \\ 1 & 1 & 1 \\ 1 & 0 & 1 \end{bmatrix}, A_{13}^4 + I_3 = \begin{bmatrix} 1 & 1 & 1 \\ 1 & 0 & 1 \\ 1 & 0 & 0 \end{bmatrix}, A_{13}^5 = \begin{bmatrix} 1 & 1 & 1 \\ 1 & 0 & 1 \\ 1 & 0 & 0 \end{bmatrix}, A_{13}^5 + I_3 = \begin{bmatrix} 0 & 1 & 1 \\ 1 & 1 & 1 \\ 1 & 0 & 1 \end{bmatrix},$$

$$A_{13}^6 = \begin{bmatrix} 1 & 0 & 1 \\ 1 & 0 & 0 \\ 0 & 1 & 0 \end{bmatrix}, A_{13}^6 + I_3 = \begin{bmatrix} 0 & 0 & 1 \\ 1 & 1 & 0 \\ 0 & 1 & 1 \end{bmatrix}$$

$$A_{14} = \begin{bmatrix} 0 & 1 & 0 \\ 0 & 0 & 1 \\ 1 & 0 & 1 \end{bmatrix} \rightarrow A_{14}^7 = I,, A_{14}^1 + I_3 = \begin{bmatrix} 1 & 1 & 0 \\ 0 & 1 & 1 \\ 1 & 0 & 0 \end{bmatrix},$$

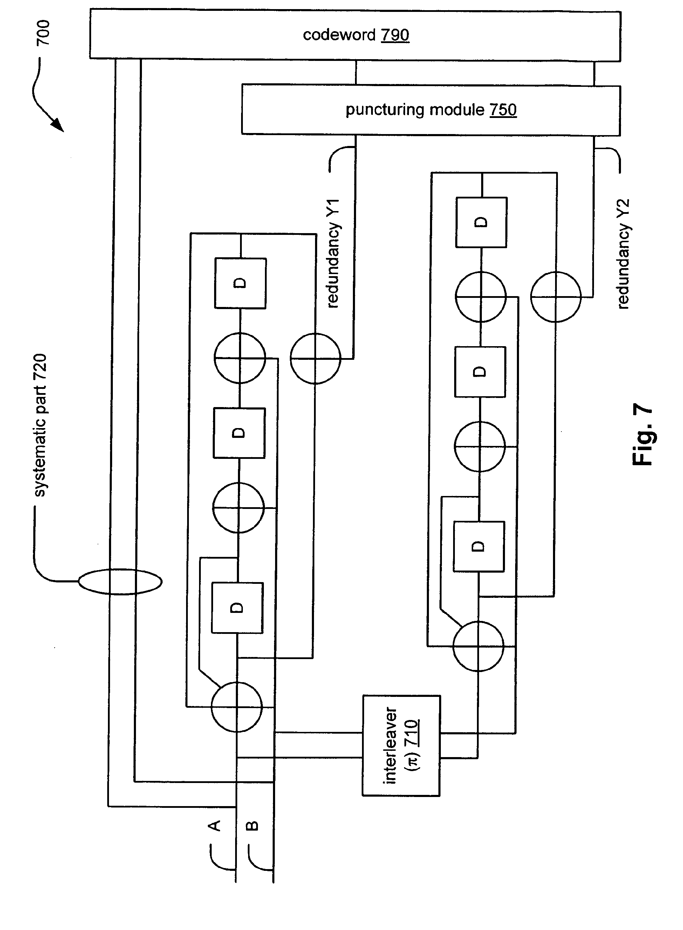

FIG. 7 illustrates an embodiment of a duo-binary turbo encoder 700. The Duo-binary turbo code [11] uses $A_{14}$ as its constituent encoder shown within the duo-binary turbo encoder 700.

Moreover, we have

$$A_{14}^2 = \begin{bmatrix} 0 & 0 & 1 \\ 1 & 0 & 1 \\ 1 & 1 & 1 \end{bmatrix}, A_{14}^2 + I_3 = \begin{bmatrix} 1 & 0 & 1 \\ 1 & 1 & 1 \\ 1 & 1 & 0 \end{bmatrix}, A_{14}^3 = \begin{bmatrix} 1 & 0 & 1 \\ 1 & 1 & 1 \\ 1 & 1 & 0 \end{bmatrix}, A_{14}^3 + I_3 = \begin{bmatrix} 0 & 0 & 1 \\ 1 & 0 & 1 \\ 1 & 1 & 1 \end{bmatrix},$$

$$A_{14}^4 = \begin{bmatrix} 1 & 1 & 1 \\ 1 & 1 & 0 \\ 0 & 1 & 1 \end{bmatrix}, A_{14}^4 + I_3 = \begin{bmatrix} 0 & 1 & 1 \\ 1 & 0 & 0 \\ 0 & 1 & 0 \end{bmatrix}, A_{14}^5 = \begin{bmatrix} 1 & 1 & 0 \\ 0 & 1 & 1 \\ 1 & 0 & 0 \end{bmatrix}, A_{14}^5 + I_3 = \begin{bmatrix} 0 & 1 & 0 \\ 0 & 0 & 1 \\ 1 & 0 & 1 \end{bmatrix},$$

$$A_{14}^6 = \begin{bmatrix} 0 & 1 & 1 \\ 1 & 0 & 0 \\ 0 & 1 & 0 \end{bmatrix}, A_{14}^6 + I_3 = \begin{bmatrix} 1 & 1 & 1 \\ 1 & 1 & 0 \\ 0 & 1 & 1 \end{bmatrix}$$

Furthermore, we can have the following proposition.

**Proposition 1** Let A=$A_{13}$ or $A_{14}$. Then for any positive integer n=7q+i, 0≤i≤6,

$$A^n + I_m = A^i + I_m = \begin{cases} 0 & i = 0 \\ invertible & i \neq 0 \end{cases}$$

We may extend Proposition 1 to the following.

**Proposition 2** Let m=2,3,4,5,6. There exists an $m \times m$ binary matrix $A$ such that $A^{2^m - B1} = I_m$. Moreover, for any such matrix $A$ and any positive integer $n = pq + i$, $0 \leq i \leq p$-1, where $p = 2^m -1$,

$$A^n + I_m = A^i + I_m = \begin{cases} 0 & i = 0 \\ invertible & i \neq 0 \end{cases}$$

New tail-biting termination method for arbitrary information length

Proposed tail-biting termination for arbitrary number of information symbols

This novel approach of performing tail-biting is based on Proposition 1. In the following we only give the method for $m = 3$ since the most likely 3GPP LTE will adapt 8 states turbo code. For the case $m = 2$ and $m > 3$ the method is similar.

Let (A,B,C,D) be state space realization of the 8 states convolutional encoder with A being similar to either $A_{13}$ or $A_{14}$ listed in the last section.

(1) Pre-compute the followings states for i=1,2,3,4,5,6

$$S_{i,1} = (A^i + I_3)^{-1} \begin{bmatrix} 0 \\ 0 \\ 1 \end{bmatrix}, S_{i,2} = (A^i + I_3)^{-1} \begin{bmatrix} 0 \\ 1 \\ 0 \end{bmatrix}, S_{i,3} = (A^i + I_3)^{-1} \begin{bmatrix} 0 \\ 1 \\ 1 \end{bmatrix},$$

$$S_{i,4} = (A^i + I_3)^{-1} \begin{bmatrix} 1 \\ 0 \\ 0 \end{bmatrix}, S_{i,5} = (A^i + I_3)^{-1} \begin{bmatrix} 1 \\ 0 \\ 1 \end{bmatrix}, S_{i,6} = (A^i + I_3)^{-1} \begin{bmatrix} 1 \\ 1 \\ 0 \end{bmatrix}, S_{i,7} = (A^i + I_3)^{-1} \begin{bmatrix} 1 \\ 1 \\ 1 \end{bmatrix}$$

(2) Pre-store the above 42 index-state pairs as a look-up-table $L(i,b_{(2)}) = S_{i,b}$, where $b = 1,2,3,4,5,6,7$ and $b_{(2)}$ is the 3 bits binary representation of $b$. Moreover, let $L(i,0) = 0$ state.

(3) Tail-biting encoding method for information block size = $k$. Let $u_0,u_1,...,u_{k-1}$ be the information symbols (or bits).

(a) Let $m = (k\bmod(7))$. If $m = 0$, pad one more symbol $u_k = 0$ and let $N = k + 1$ and $M = 1$, otherwise let $N = k$ and $M = m$.

(b) With $S_{initial}$ state encoding information symbols $u_0,u_1,...,u_{N-1}$ to find the final state $S_{final}$ (do not store the encoded symbols). Then use Look-up table to find the initial state $S_0 = L(M, S_{final} - A^M S_{initial})$. If desired in some embodiments, $S_{initial}$ state can be selected to be 0.

(c) Use $S_0$ as initial state to encode $u_0,u_1,...,u_{N-1}$.

The novel tail-biting termination approach provided herein offers significant improvement over previous approaches. This novel means provides for more flexibility that other means. For example, any block size or any sized input sequence (i.e., any number of information symbols or bits in the input sequence) can benefit from the tail-biting termination approach provided herein. In addition, the novel approach presented herein has less overhead that other approaches. At most 1 symbol (or 1 bit) overhead may be required. In most cases, there is no overhead at all as no extra symbols (or bits) are required to ensure the tail-biting termination. Also, the novel means provided herein has relatively better throughput/data rate than those approaches which merely adding $2m$ overhead termination symbols (or bits) for a $2^m$ (i.e., $2^{\wedge}m$) state convolutional code such as that used in 3GPP Rel.6 turbo codes and other turbo codes. The approach of merely adding $2m$ overhead termination symbols (or bits) reduces throughput and data rate. The novel approach presented herein also has relatively better performance that other approaches. In this novel approach presented herein, all the bits (including the at most one symbol (or bit) that may be padded to the input sequence) are interleaved within the turbo encoding. Compared to other approaches, such as those that employ the 2m overhead termination symbols or bits (e.g., the 6 termination symbols or bits required in an 8 state encoder, 3 6 termination symbols or bits to each of the constituent encoders), those 2m overhead termination symbols or bits are not interleaved. In the novel approach presented herein, all of the symbols or bits of the input sequence (including the at most one symbol (or bit) that may be padded to the input sequence) undergo the interleaving.

Above, it is shown that no prior art approach can provide complete operation of tail-biting for all constituent encoders (e.g., as employed within a turbo encoder) for all information sequence sizes.

Herein, a novel approach is made for tail-biting termination for all possible sizes of input sequence that may be provided to a turbo encoder. In one instance, this can be applied to all input sequence sizes that may be employed for 3GPP LTE turbo coding. In addition, only at most 1 overhead symbol or bit may be required to be padded to the input sequence to achieve the tail-biting functionality. Other prior art approaches, need at least $2m$ symbols or bits when operating using a turbo encoder whose constituent encoders have $2^m$ (i.e., $2^{\wedge}m$) states.

For one illustrative example, when considering the 3GPP LTE turbo coding, then according to this novel means presented herein, at most one dummy symbol or bit is added to 1/7 of all possible input sequence sizes. In that application (3GPP LTE turbo coding), there is no extra symbol or bit (i.e., no padding at all) that needs to be added to the other 6/7 input sequence sizes. This novel approach allows tail-biting termination for input sequences that include information block sizes of any arbitrary size. The novel tail-biting approach presented herein can be used for a turbo coding system that support an arbitrary information bits within its input sequence. In fact, this novel approach presented herein can be applied to all communication system as it can support an arbitrary number of information bits. For example, the turbo coding such as that being designed for 3GPP LTE, in which various sized input sequence sizes should be supported, can benefit significantly from this novel approach's ability to accommodate any input sequence size.

Moreover, the novel means presented herein introduces no performance as compared to the undesirable loss introduced within those prior art approaches than implement the termination outside of the interleaver of the turbo encoder (i.e., in those prior art approaches, the at least 2m symbols or bits employed for termination do not pass through the interleaver of the turbo encoder).

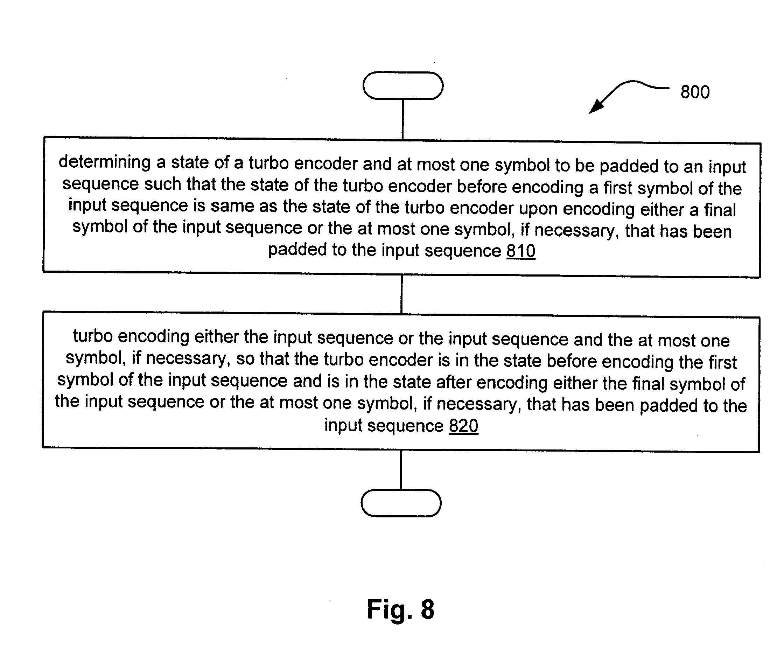

FIG. 8 illustrates an embodiment of a method 800 for performing tail-biting within a turbo encoder that encodes an input sequence. In the block 810, the method 800 begins by determining a state of a turbo encoder and at most one symbol to be padded to an input sequence such that the state of the turbo encoder before encoding a first symbol of the input sequence is same as the state of the turbo encoder upon encoding either a final symbol of the input sequence or the at most one symbol, if necessary, that has been padded to the input sequence. Then, as shown in a block 820, the method 800 continues by performing turbo encoding either the input sequence or the input sequence and the at most one symbol, if necessary, so that the turbo encoder is in the state before encoding the first symbol of the input sequence and is in the state after encoding either the final symbol of the input sequence or the at most one symbol, if necessary, that has been padded to the input sequence.

The present invention has also been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope and spirit of the claimed invention.

The present invention has been described above with the aid of functional building blocks illustrating the performance of certain significant functions. The boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality. To the extent used, the flow diagram block boundaries and sequence could have been defined otherwise and still perform the certain significant functionality. Such alternate definitions of both functional building blocks and flow diagram blocks and sequences are thus within the scope and spirit of the claimed invention.

One of average skill in the art will also recognize that the functional building blocks, and other illustrative blocks, modules and components herein, can be implemented as illustrated or by discrete components, application specific integrated circuits, processors executing appropriate software and the like or any combination thereof.

Moreover, although described in detail for purposes of clarity and understanding by way of the aforementioned embodiments, the present invention is not limited to such embodiments. It will be obvious to one of average skill in the art that various changes and modifications may be practiced within the spirit and scope of the invention, as limited only by the scope of the appended claims.

**REFERENCES**

[1] System impact of Rel'6 turbo coding tail-bits removal, R1-062157.

[2] 3GPP TS 25.212 V6.8.0 (2006-06), 3rd Generation Partnership Project; Technical Specification Group Radio Access Network; Multiplexing and channel coding (FDD) (Release 6)

[3] John B. Anderson and Stephen M. Hladik, "Tailbiting MAP Decoders," IEEE Journal on Selected Areas in Communications, Vol. 16, No. 2, February 1998, pp. 297-302.

[4] J. L. Massey and M. K. Sain, "Codes, automata, and continuous systems: Explicit interconnections," IEEE Trans. Automat. Contr., vol. AC-12, no. 6, pp. 644-650, 1967.

[5] Robert J. McEliece. The Algebraic Theory of Convolutional Codes. In Handbook of Coding Theory, R. Brualdi, W.C. Human and V. Pless (eds.). Elsevier Science Publishers, Amsterdam, The Netherlands, 1998.

[6] J. Rosenthal, and E. V. York, "BCH Convolutional Codes," IEEE Transactions on Information Theory, Vol.45, No.6, PP.1833-1842, Sept. 1999

[7] C. Weiß, C. Bettstetter and S. Riedel, "Code Construction and Decoding of Parallel Concatenated Tail-Biting Codes," IEEE Transactions on Information Theory, Vol. 47, No. 1, pp.366-386, Jan. 2001.

[8] H. Gluesing-Luerssen and G. Schneider," State space realizations and monomial equivalence for convolutional codes", arXiv:cs.IT/0603049, Mar. 2006.

[9] Claude Berrou, Alain Glavieux, and Punya Thitimajshima, "Near Shannon limit error-correcting coding and decoding: turbo codes", Proc. of IEEE ICC '93, Geneva, May 1993, pp. 1064-1070.

[10] C. Fragouli and R. Wesel, "Turbo-Encoder Design for Symbol-Interleaved Parallel Concatenated Trellis-Coded Modulation," IEEE Transactions on Communications, Vol. 49, No.3,pp. 425-435, March 2001.

[11] Duo-Binary Turbo Codes for Evolved UTRA, 3GPP TSG RAN WG1#46,R1-061973.

**Claims**

**1.** An encoder that is operable to perform tail-biting when encoding an input sequence, the encoder comprising:

a buffer that is operable to receive the input sequence;
a turbo encoder that is operable to receive the input sequence from the buffer and to encode the input sequence; and
a processing module that, based on the input sequence, is operable to determine a state of the turbo encoder and at most one symbol to be padded to the input sequence such that the state of the turbo encoder before encoding a first symbol of the input sequence is same as the state of the turbo encoder upon encoding a final symbol of the input sequence or the at most one symbol that has been padded to the input sequence; and wherein:
the buffer is operable to provide the input sequence to the turbo encoder when the processing module determines the state; and
the turbo encoder is in the state that is determined by the processing module before encoding the first symbol of the input sequence and after encoding the final symbol of the input sequence or the at most one symbol that has been padded to the input sequence.

2. The encoder of claim 1, wherein:

at least one of the first symbol and the second symbol includes only one bit.

3. The encoder of claim 1, wherein:

the processing module is operable to provide the at most one symbol to be padded to the input sequence to the turbo encoder after the buffer provides the input sequence to the turbo encoder.

4. The encoder of claim 1, further comprising:

a puncturing module that is operable to puncture at least one bit within an encoded sequence output from the turbo encoder.

5. The encoder of claim 1, wherein:

based on the input sequence, the processing module is operable to determine that no symbol needs to be padded to the input sequence to ensure that the state of the turbo before encoding a first symbol of the input sequence is same as the state of the turbo encoder upon encoding a final symbol of the input sequence.

6. An encoder that is operable to perform tail-biting when encoding an input sequence, the encoder comprising:

a turbo encoder that is operable to receive an input sequence and to encode either:

the input sequence; or
the input sequence and at most one zero valued symbol that is padded to the input sequence; and

a processing module that, based on the input sequence, is operable to determine a starting state of the turbo encoder, and to provide the starting state to the turbo encoder, so that the starting state of the turbo encoder before encoding a first symbol of the input sequence is same as an ending state of the turbo encoder upon encoding either a final symbol of the input sequence or the at most one zero valued symbol when padded to the input sequence.

7. The encoder of claim 6, wherein:

at least one of the first symbol and the second symbol includes only one bit.

8. The encoder of claim 6, further comprising:

a buffer that is operable to receive the input sequence; and wherein:

the buffer provides the input sequence to the turbo decoder after the processing module determines the starting state of the encoder; and
the processing module provides the at most one zero valued symbol, when determined necessary by the processing module, to the turbo encoder after the buffer provides the input sequence to the turbo decoder.

9. A method for performing tail-biting within a turbo encoder that encodes an input sequence, the method comprising:

determining a state of the turbo encoder and at most one symbol to be padded to the input sequence such that the state of the turbo encoder before encoding a first symbol of the input sequence is same as the state of the turbo encoder upon encoding either a final symbol of the input sequence or the at most one symbol, if necessary, that has been padded to the input sequence; and
turbo encoding either the input sequence or the input sequence and the at most one symbol, if necessary, so that the turbo encoder is in the state before encoding the first symbol of the input sequence and is in the state after encoding either the final symbol of the input sequence or the at most one symbol, if necessary, that has been padded to the input sequence.

**10.** The method of claim 9, further comprising:

at least one of the first symbol and the second symbol includes only one bit.

Fig. 1

**Fig. 2**

**Fig. 3**

**Fig. 4**

Fig. 5

uncoded BPSK 511

transfer function bound 510

VA decoder, unknown start and stop states 501

VA decoder, 6-bit terminated (e.g., 3 bits to each encoder) 502

coded BPSK 513

500

VA BCJR, algorithm 3 504

tail-biting VA decoder 503

Measured BER

Eb/No (dB)

Fig. 6

Fig. 7

800

determining a state of a turbo encoder and at most one symbol to be padded to an input sequence such that the state of the turbo encoder before encoding a first symbol of the input sequence is same as the state of the turbo encoder upon encoding either a final symbol of the input sequence or the at most one symbol, if necessary, that has been padded to the input sequence 810

turbo encoding either the input sequence or the input sequence and the at most one symbol, if necessary, so that the turbo encoder is in the state before encoding the first symbol of the input sequence and is in the state after encoding either the final symbol of the input sequence or the at most one symbol, if necessary, that has been padded to the input sequence 820

**Fig. 8**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 847773 P
- US 7085985 B

### Non-patent literature cited in the description

- *3rd Generation Partnership Project; Technical Specification Group Radio Access Network*
- **JOHN B. ANDERSON ; STEPHEN M. HLADIK.** Tailbiting MAP Decoders. *IEEE Journal on Selected Areas in Communications,* February 1998, vol. 16 (2), 297-302
- **J. L. MASSEY ; M. K. SAIN.** Codes, automata, and continuous systems: Explicit interconnections. *IEEE Trans. Automat. Contr.,* 1967, vol. AC-12 (6), 644-650
- The Algebraic Theory of Convolutional Codes. **ROBERT J. MCELIECE.** Handbook of Coding Theory. Elsevier Science Publishers, 1998
- **J. ROSENTHAL ; E. V. YORK.** BCH Convolutional Codes. *IEEE Transactions on Information Theory,* September 1999, vol. 45 (6), 1833-1842
- **C. WEIß ; C. BETTSTETTER ; S. RIEDEL.** Code Construction and Decoding of Parallel Concatenated Tail-Biting Codes. *IEEE Transactions on Information Theory,* January 2001, vol. 47 (1), 366-386
- **H. GLUESING-LUERSSEN ; G. SCHNEIDER.** State space realizations and monomial equivalence for convolutional codes. *arXiv:cs.IT/0603049,* March 2006
- **CLAUDE BERROU ; ALAIN GLAVIEUX ; PUNYA THITIMAJSHIMA.** Near Shannon limit error-correcting coding and decoding: turbo codes. *Proc. of IEEE ICC '93,* May 1993, 1064-1070
- **C. FRAGOULI ; R. WESEL.** Turbo-Encoder Design for Symbol-Interleaved Parallel Concatenated Trellis-Coded Modulation. *IEEE Transactions on Communications,* March 2001, vol. 49 (3), 425-435
- Duo-Binary Turbo Codes for Evolved UTRA. *3GPP TSG RAN WG1#46,R1-061973*